# EUROPEAN PATENT APPLICATION

(11) **EP 4 570 093 A1**
(43) Date of publication of application: **18.06.2025**
(21) Application number: 22957007.2
(22) Date of filing: 02.09.2022
(51) Int. Cl.: A24F 40/46, A24F 40/50

(54) **MICROWAVE GENERATION APPARATUS AND ATOMIZATION DEVICE**

(71) Applicant: Shenzhen Merit Technology Co., Ltd., Shenzhen, Guangdong 518105 (CN)
(72) Inventor: YIN, Kunren, Shenzhen, Guangdong 518105 (CN); LIANG, Feng, Shenzhen, Guangdong 518105 (CN)
(74) Representative: Westphal, Mussgnug & Partner, Patentanwälte mbB
(86) International application number: PCT/CN2022/116852
(87) International publication number: WO 2024/045187

(57) **Abstract**

A microwave generation apparatus (10) and an atomization device (100). The microwave generation apparatus (10) comprises a voltage-controlled oscillator (11) and multiple stages of power amplification modules (13), which are connected in series. The voltage-controlled oscillator (11) generates a high-frequency radio frequency signal. The multiple stages of power amplification modules (13) receive the radio frequency signal, perform power amplification on the radio frequency signal, and output the amplified radio frequency signal to a load (30); and the multiple stages of power amplification modules (13) are arranged on the same substrate to form an integrated chip.

## Description

### FIELD

The application relates to the technical field of electronic atomization, and more specifically relates to a microwave generation apparatus and an atomization device.

### BACKGROUND

Atomization devices, such as atomized electronic cigarettes, have been sought after by many users because of their relatively healthy and high cost effectiveness. With the increasing demand of users for atomization taste and aerosol quantity, current atomization devices usually need to output higher power to produce more aerosol to meet the user's taste demand for greater power. However, to output higher power, it is usually necessary to set more cascade circuits, and each stage has its own peripheral matching circuit and power transmission microstrip, which will occupy a large area and is not conducive to the miniaturization of atomization devices.

### SUMMARY

The embodiment of the application provides a microwave generation apparatus and an atomization device.

In some embodiments, the microwave generation apparatus provided by the application comprises a voltage-controlled oscillator and multiple stages of power amplification modules connected in series. The voltage-controlled oscillator is used for generating a high-frequency radio frequency signal. The multiple stages of power amplification modules are connected with the voltage-controlled oscillator and used for receiving the radio frequency signal and performing power amplification on the radio frequency signal to output the amplified radio frequency signal to a load, and multiple stages of power amplification modules are arranged on the same substrate to form an integrated chip.

In some embodiments, the multiple stages of power amplification modules and the voltage-controlled oscillator are arranged on the same substrate to form the integrated chip.

In some embodiments, the multiple stages of power amplification modules comprise a first-stage power amplification module, a second-stage power amplification module, and a third-stage power amplification module; the first-stage power amplification module, the second-stage power amplification module, and the third-stage power amplification module are sequentially connected in series between the voltage-controlled oscillator and the load, and amplify the radio frequency signal output by the voltage-controlled oscillator stage by stage.

In some embodiments, the first-stage power amplification module comprises a first chip, a resistor R6, a resistor R7, a resistor R8, a resistor R13, a resistor R15, a resistor R16, a resistor R19, a capacitor C21, a capacitor C22, a capacitor C24, a capacitor C26, a capacitor C36, a capacitor C42, an emitter capacitor CE, an inductor L2, and an inductor L3, the first pin of the first chip is connected to the output pin of the voltage-controlled oscillator through the capacitor C36 and the resistor R6 in series; One end of the resistor R7 is connected between the resistor R6 and the output pin of the voltage-controlled oscillator, and the other end of the resistor R7 is grounded; one end of the resistor R8 is connected between the resistor R6 and the capacitor C36, and the other end of the resistor R8 is connected with the other end of the resistor R7; the second pin of the first chip is connected with one end of the inductor L3, the other end of the inductor L3 is connected with a first power supply, and the capacitor C42 is connected between the inductor L3 and the first power supply; the third pin and the fourth pin of the first chip are grounded; the fifth pin of the first chip is connected with the first power supply through the resistor R15, one end of the capacitor C21 is connected between the first power supply and the resistor R15, and the other end of the capacitor C21 is grounded; the sixth pin of the first chip is connected with the first power supply through the resistor R16, and one end of the capacitor C22 is connected between the first power supply and the R16, and the other end of the capacitor C22 is grounded; the seventh pin of the first chip is connected with the emitter capacitor CE through the resistor R19, one end of the capacitor C26 is connected between the resistor R19 and the seventh pin of the first chip, the other end of the capacitor C26 is grounded; one end of the resistor R13 is connected between the resistor R19 and the seventh pin of the first chip, and the other end of the resistor R13 is connected with the other end of the capacitor C26; the eighth pin and the ninth pin of the first chip are electrically connected and then connected with the second-stage power amplification module through a DC blocking capacitor C50; One end of the inductor L2 is connected between the eighth pin of the first chip and the DC blocking capacitor C50, and is connected between the ninth pin of the first chip and the DC blocking capacitor C50, and the other end of the inductor L2 is connected with a second power supply; One end of the capacitor C24 is connected between the inductor L2 and the second power supply, and the other end of the capacitor C24 is grounded.

In some embodiments, the second-stage power amplification module comprises a second chip, a capacitor C41, a capacitor C51, a capacitor C52, a capacitor C53, and an inductor L4, the first pin of the second chip is connected with the first-stage power amplification module through a DC blocking capacitor C50, and one end of the capacitor C52 is connected between the DC blocking capacitor C50 and the first pin of the second chip, and the other end of the capacitor C52 is connected with the second pin of the second chip; the second pin of the second chip is grounded; the third pin of the second chip is connected with the third-stage power amplification module through a DC blocking capacitor C37, one end of the inductor L4 is connected between the third pin of the second chip and the DC blocking capacitor C37, and the other end of the inductor L4 is connected with a third power supply; one end of the capacitor C41 is connected between the inductor L4 and the third power supply, and the other end of the capacitor C41 is grounded; one end of the capacitor C51 is connected between the third pin of the second chip and the inductor L4, and the other end of the capacitor C51 is connected with the second pin of the second chip; one end of the capacitor C51 is connected between the inductor L4 and the DC blocking capacitor C37, and the other end of the capacitor C51 is connected with the second pin of the second chip.

In some embodiments, the load comprises a cavity for storing a matrix and an FMA terminal arranged on the cavity; the third-stage power amplification module comprises a third chip, a variable resistor RT11, a resistor R14, a resistor R36, a capacitor C20, a capacitor C39, a capacitor C54, a power supply VG, and a diode VD; the first pin and the second pin of the third chip are electrically connected and then connected with the second-stage power amplification module through a DC blocking capacitor C37; one end of the resistor R14 is connected between the first pin of the third chip and the DC blocking capacitor C37, and is connected between the second pin of the third chip and the DC blocking capacitor C37, the other end of the resistor R14 is connected with the power supply VG; the variable resistor RT11 is arranged between the power supply VG and the resistor R14, the first end of the variable resistor RT11 is connected with a fourth power supply, the second end of the variable resistor RT11 is grounded, and the third end of the variable resistor RT11 is connected between the power supply VG and the resistor R14; one end of the capacitor C20 is connected between the resistor R14 and the power supply VG, and the other end of the capacitor C20 is grounded; one end of the resistor R36 is connected to the third end of the variable resistor RT11, and the other end of the resistor R36 is connected to the second end of the variable resistor RT11; the third pin and the fourth pin of the third chip are electrically connected and then connected with the first pin of a circulator T1 through a DC blocking capacitor C38; the second pin of the circulator T1 is connected with the FMA terminal; the diode VD is connected between the third pin of the third chip and the DC blocking capacitor C38, and is connected between the fourth pin of the third chip and the DC blocking capacitor C38; one end of the capacitor C39 is connected between the third pin of the third chip and the diode VD, and is connected between the fourth pin of the third chip and the diode VD, and the other end of the capacitor C39 is grounded; one end of the capacitor C54 is connected between the DC blocking capacitor C38 and the diode VD, and the other end of the capacitor C54 is grounded; the fifth pin of the third chip is grounded.

In some embodiments, the material of the substrate is at least one of ceramic or metal.

In some embodiments, the atomization device provided by the application comprises a microcontroller and a microwave generation apparatus. The microcontroller is electrically connected with the microwave generation apparatus. The microwave generation apparatus comprises a voltage-controlled oscillator and a multiple stages of power amplification modules connected in series. The voltage-controlled oscillator is used for generating high-frequency radio frequency signals. The multiple stages of power amplification modules are connected with the voltage-controlled oscillator and used for receiving the radio frequency signal and performing power amplification on the radio frequency signal to output the amplified radio frequency signal to a load, and multiple stages of power amplification modules are arranged on the same substrate to form an integrated chip.

In some embodiments, the atomization device further comprises a forward power detection module. The forward power detection module is used for detecting the power of the radio frequency signal after being amplified by the multiple stages of power amplification modules and outputting a first voltage to the microcontroller, wherein the microcontroller turns off the voltage-controlled oscillator when the power of the radio frequency signal is greater than or less than a preset range.

In some embodiments, the forward power detection module and the multiple stages of power amplification modules are arranged on the same substrate to form the integrated chip.

In some embodiments, the forward power detection module, the voltage-controlled oscillator, and the multiple stages of power amplification modules are arranged on the same substrate to form the integrated chip.

In some embodiments, the forward power detection module comprises a fourth chip, a resistor R18, a resistor R24, a resistor R26, a resistor R28, a resistor R35, a resistor R37, a capacitor C27, a capacitor C29, a capacitor C31, a capacitor C33, a capacitor C61, and a power supply VCC, wherein the first pin of the fourth chip is connected with a power supply VCC, and one end of the capacitor C31 is connected between the first pin of the fourth chip and the power supply VCC, and the other end of the capacitor C31 is grounded; the second pin of the fourth chip is connected with one end of the resistor R35, and the other end of the resistor R35 is connected between the first pin of the fourth chip and the capacitor C31; the third pin of the fourth chip is connected with the microcontroller through the resistor R37; the fourth pin of the fourth chip is grounded; one end of the capacitor C33 is connected between the third pin of the fourth chip and the resistor R37, and the other end of the capacitor C33 is connected with the fourth pin of the fourth chip; the fifth pin of the fourth chip is grounded; one end of the capacitor C29 is connected with the sixth pin of the fourth chip, and the other end of the capacitor C29 is connected with the fifth pin of the fourth chip; the seventh pin of the fourth chip is grounded through the capacitor C27, the resistor R26, the capacitor C61, a first coupling line, and the R18 connected in series, the first coupling line is coupled with a second coupling line which is connected between the DC blocking capacitor C38 and the circulator T1; one end of the resistor R28 is connected between the resistor R26 and the capacitor C27, and the other end of the resistor R28 is grounded; one end of the resistor R24 is connected between the resistor R26 and the capacitor C61, and the other end of the resistor R24 is grounded.

In some embodiments, the atomization device further comprises a reverse power detection module. The reverse power detection module is used for detecting the power reflected by the microwave in the load and outputting a second voltage to the microcontroller; and the microcontroller performs algorithmic processing on the first voltage and the second voltage to output a resonant frequency; and the microcontroller controls the frequency of the radio frequency signal output by the voltage-controlled oscillator according to the resonant frequency.

In some embodiments, the reverse power detection module and the multiple stages of power amplification modules are arranged on the same substrate to form the integrated chip.

In some embodiments, the reverse power detection module, the voltage-controlled oscillator, and the multiple stages of power amplification modules are arranged on the same substrate to form the integrated chip.

In some embodiments, the reverse power detection module comprises a fifth chip, a resistor R91, a resistor R95, a capacitor C89, a capacitor C91, a capacitor C92, a capacitor C93 and a power supply VCC, the first pin of the fifth chip is connected with the power supply VCC; one end of the capacitor C91 is connected between the first pin of the fifth chip and the power supply VCC, and the other end of the capacitor C91 is grounded; the second pin of the fifth chip is connected with one end of the resistor R95, and the other end of the resistor R95 is connected between the first pin of the fifth chip and the capacitor C91; the third pin of the fifth chip is connected with the microcontroller; one end of the capacitor C93 is connected between the third pin of the fifth chip and the microcontroller, and the other end of the capacitor C93 is connected with the fourth pin of the fifth chip, and the fourth pin of the fifth chip is grounded; the fifth pin of the fifth chip is grounded; the sixth pin of the fifth chip is connected with one end of the capacitor C89, and the other end of the capacitor C89 is connected with the fifth pin of the fifth chip; one end of resistor R17 is connected with circulator T1 through a third coupling line, and the other end of the resistor R17 is grounded; the seventh pin of the fifth chip is grounded through the capacitor C92, a fourth coupling line, and the resistor R91 connected in series, and the fourth coupling line is coupled with the first coupling line.

In some embodiments, the atomization device further comprises a temperature detection module. The temperature detection module detects the temperature in the load and outputs a third voltage; wherein the microcontroller turns off the voltage-controlled oscillator when the temperature in the load is greater than a preset temperature range.

In some embodiments, the temperature detection module comprises a thermistor RT1 and a resistor R99, one end of the resistor R99 is electrically connected with the microcontroller, and the other end of the resistor R99 is connected with a first power supply; one end of the thermistor RT1 is connected between the microcontroller and the resistor R99, and the other end of the thermistor RT1 is grounded.

In some embodiments, the microcontroller comprises a sixth chip and a capacitor C3, the first pin of the sixth chip is connected with a first power supply, one end of the capacitor C3 is connected between the first pin of the sixth chip and the first power supply, and the other end of the capacitor C3 is grounded; the second pin, the third pin, and the fourth pin of the sixth chip are all electrically connected with the voltage-controlled oscillator; the fifth pin of the sixth chip is grounded; the sixth pin of the sixth chip is electrically connected with the reverse power detection module; the seventh pin of the sixth chip is electrically connected with the forward power detection module; the eighth pin of the sixth chip is electrically connected with the temperature detection module.

In some embodiments, the voltage-controlled oscillator comprises a seventh chip, a resistor R1, a resistor R5, a resistor R9, a capacitor C1, a capacitor C2, a capacitor C10, a capacitor C12, a capacitor C14, a capacitor C15, a capacitor C16, a capacitor C17, a capacitor C18, an inductor L1, and a crystal oscillator Y1, the first pin, the second pin, and the third pin of the seventh chip are electrically connected and then connected with a first power supply; one end of the capacitor C10 is connected between the first power supply and the third pin of the seventh chip, and the other end of the capacitor C10 is grounded; the fourth pin of the seventh chip is connected with one end of the capacitor C12, and the other end of the capacitor C12 is connected between the capacitor C10 and the third pin of the seventh chip; the fifth pin of the seventh chip is connected with the first-stage power amplification module through a DC blocking capacitor C13, and one end of the inductor L1 is connected between the capacitor C10 and the capacitor C12, and the other end of the inductor L1 is connected between the DC blocking capacitor C13 and the fifth pin of the seventh chip; the sixth pin of the seventh chip is connected with one end of the capacitor C17, and the other end of the capacitor C17 is grounded; the seventh pin of the seventh chip is grounded; the eighth pin of the seventh chip is connected with one end of the capacitor C16, and the other end of the capacitor C16 is grounded; the ninth pin of the seventh chip is connected with one end of the resistor R9 through the capacitor C15, the other end of the resistor R9 is grounded; one end of the resistor R5 is connected between the ninth pin of the seventh chip and the capacitor C15, the other end of the resistor R5 is connected between the eighth pin of the seventh chip and the capacitor C16; one end of the capacitor C14 is connected between the resistor R5 and the capacitor C15, and the other end of the capacitor C14 is grounded; the tenth pin, the eleventh pin, and the twelfth pin of the seventh chip are all electrically connected with the microcontroller; the thirteenth pin of the seventh chip is connected with the third pin of the crystal oscillator Y1 through the capacitor C1 and the capacitor C2 connected in series, the fourth pin of the crystal oscillator Y1 is connected with the first power supply, the first pin of the crystal oscillator Y1 is floating, the second pin of the crystal oscillator Y1 is grounded; one end of the resistor R1 is connected between the capacitor C1 and the capacitor C2, and the other end of the resistor R1 is grounded; one end of capacitor C18 is connected between the fourth pin of crystal Y1 and the first power supply, and the other end of the capacitor C18 is grounded.

According to the microwave generation apparatus and the atomization device, the multiple stages of power amplification modules connected in series are arranged, so that the power of the radio frequency signal sent by the voltage-controlled oscillator is improved, the power requirement of the atomization device is fully met, the atomization taste and aerosol quantity are improved, and avoid the mismatch of power failing to produce atomization or insufficient atomization that affects the taste. At the same time, the multiple stages of power amplification modules are arranged on the same substrate to form an integrated chip, which reduces the space occupied by the multiple stages of power amplification modules, improves the efficiency of the overall amplification link, and ensures the miniaturization of microwave generation apparatus and atomization device.

Additional aspects and advantages of the embodiments of the present application will be set forth in part in the description which follows, and in part will be obvious from the description which follows, or may be learned by practice of the embodiments of the present application.

### BRIEF DESCRIPTION OF THE DRAWINGS

The above and/or additional aspects and advantages of the present application will be apparent and easily understood from the description of the embodiments taken in conjunction with the following drawings, in which:
Fig. 1 is a modular connection block diagram of an atomization device according to some embodiments of the present application;
Fig. 2 is a schematic circuit diagram of a first-stage power amplification module in a microwave generation apparatus according to some embodiments of the present application;
Fig. 3 is a schematic circuit diagram of the second-stage power amplification module in the microwave generation apparatus according to some embodiments of the present application;
Fig. 4 is a schematic circuit diagram of a load in an atomization device according to some embodiments of the present application;
Fig. 5 is a schematic structural view of a load in an atomization device according to some embodiments of the present application;
Fig. 6 is a schematic circuit diagram of the third-stage power amplification module in the microwave generation apparatus according to some embodiments of the present application;
Fig. 7 is a schematic circuit diagram of a forward power detection module in an atomization device according to some embodiments of the present application;
Fig. 8 is a schematic circuit diagram of a reverse power detection module in an atomization device according to some embodiments of the present application;
Fig. 9 is a schematic circuit diagram of a microcontroller and a temperature detection module in an atomization device according to some embodiments of the present application; and
Fig. 10 is a schematic circuit diagram of a voltage-controlled oscillator in an atomization device according to some embodiments of the present application.

### DETAILED DESCRIPTION

Hereinafter, embodiments of the present application will be described in detail, examples of which are shown in the accompanying drawings, and the same or similar reference numerals indicate the same or similar elements or elements with the same or similar functions throughout. The embodiments described below by referring to the attached drawings are exemplary and are only used to explain the application, and cannot be understood as limitations of the application.

The following disclosure provides many different embodiments or examples to realize different structures of the embodiments of the present application. To simplify the disclosure of embodiments of the present application, components, and arrangements of specific examples are described below. Of course, they are only examples and are not intended to limit the application.

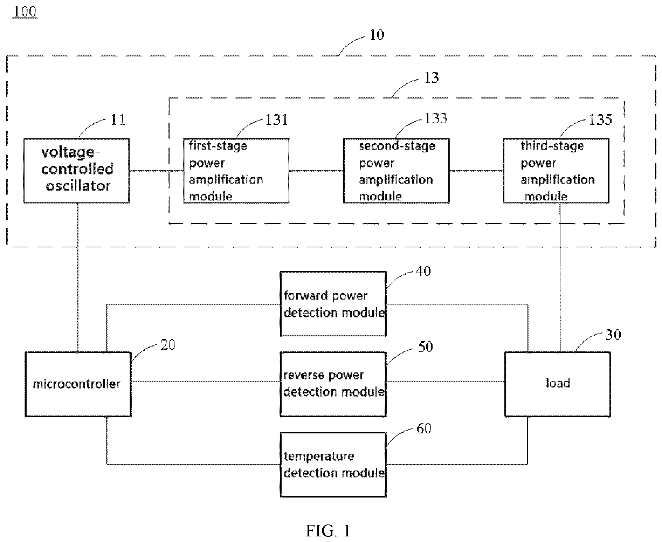

Atomization devices, such as atomized electronic cigarettes, have been sought after by many users because of their relatively healthy and high cost effectiveness. With the increasing demand of users for atomization taste and aerosol quantity, current atomization devices usually needs to output higher power to produce more aerosol to meet the user's taste demand for greater power. However, to output higher power, it is usually necessary to set more cascade circuits, and each stage has its own peripheral matching circuit and power transmission microstrip, which will occupy a large area and is not conducive to the miniaturization of atomization devices. Referring to Fig. 1, to solve this problem, the present application provides a microwave generation apparatus 10 and an atomization device 100.

Referring to Fig. 1, an embodiment of the present application provides a microwave generation apparatus 10. The microwave generation apparatus 10 includes a voltage-controlled oscillator 11 and series-connected multiple stages of power amplification modules 13. The voltage-controlled oscillator 11 is used to generate high-frequency radio frequency signals. The multiple stages of power amplification modules 13 are connected with the voltage-controlled oscillator 11 and are used for receiving radio frequency signals and performing power amplification on the radio frequency signals to output the amplified radio frequency signals to a load 30. The multiple stages of power amplification modules 13 are arranged on the same substrate to form an integrated chip.

Among them, the frequency of the radio frequency signal can be 2.45GHz, and the multiple stages of power amplification modules 13 are connected in series and sequentially amplify the power of the received radio frequency signals, so that the power of the radio frequency signals can meet the high power requirement of a large of aerosol quantity, and the taste of the atomization device 100 is improved. It should be noted that in some embodiments, the frequency of the radio frequency signal can also be other frequency values.

In some embodiments, the number of the power amplification modules can be set to 2, 3, 4, or even more, which is not limited here. In this application, only three power amplification modules are illustrated, and the three power amplification modules are connected in series.

The microwave generation apparatus 10 according to the embodiment of the present application is provided with the multiple stages of power amplification modules 13 connected in series, to increase the power of the radio frequency signal sent by the voltage-controlled oscillator 11, fully meet the power demand of the atomization device 100, ensure the improvement of the atomization taste and the aerosol quantity, and avoid the mismatch of power failing to produce atomization or insufficient atomization that affects the taste. At the same time, the multiple stages of power amplification modules 13 are arranged on the same substrate to form an integrated chip, which reduces the space occupied by the multiple stages of power amplification modules 13, improves the efficiency of the overall amplification link, and ensures the miniaturization of the microwave generation apparatus 10 and the atomization device 100.

In some embodiments, the multiple stages of power amplification modules 13 and the voltage-controlled oscillator 11 are arranged on the same substrate to form an integrated chip.

Specifically, the voltage-controlled oscillator 11 is electrically connected with the multiple stages of power amplification modules 13, and the high-frequency Radio frequency signal generated by the voltage-controlled oscillator 11 is directly transmitted to the multiple stages of power amplification modules 13 for power amplification so that the gain can be improved, the overall efficiency of the overall amplification link can be improved, and the working efficiency of the microwave generation apparatus 10 and the atomization device 100 can be further improved.

In addition, the voltage-controlled oscillator 11 and the multiple stages of power amplification modules 13 are arranged on the same substrate to form an integrated chip, which reduces the matching circuit and power transmission microstrip around the multiple stages of power amplification modules 13, thereby reducing the circuit area, further reducing the space occupancy rate of the microwave generation apparatus 10, and ensuring the miniaturization of the microwave generation apparatus 10 and the atomization device 100.

In some embodiments, the material of the substrate is at least one of ceramic or metal.

Specifically, the voltage-controlled oscillator 11 and the multiple stages of power amplification modules 13 generate a certain amount of heat during operation. Under high heat conditions, the resistance in the multiple stages of power amplification modules 13 increases, which reduces the output power of the multiple stages of power amplification modules 13, and further cause the atomization device 100 to be unable to generate enough atomization due to insufficient output power, which will affect the taste, or even completely unable to atomize. The bottom of the integrated chip is made of a ceramic substrate or a metal substrate, which can improve the thermal uniformity and heat dissipation effect of the integrated chip and avoid heat accumulation, thus ensuring that the output power is large enough, and further ensuring that the atomization amount of the atomization device 100 is sufficient and the taste is good.

Please refer to Fig. 1 again. In some embodiments, the multiple stages of power amplification modules 13 may include a first-stage power amplification module 131, a second-stage power amplification module 133, and a third-stage power amplification module 135. Wherein, the first-stage power amplification module 131, the second-stage power amplification module 133, and the third-stage power amplification module 135 are sequentially connected in series between the voltage-controlled oscillator 11 and the load 30, and amplify the radio frequency signal output by the voltage-controlled oscillator 11 stage by stage.

In one embodiment, the amplification ratios among the first-stage power amplification module 131, the second-stage power amplification module 133, and the third-stage power amplification module 135 can be different. For example, the amplification ratio of the first-stage power amplification module 131 is 20db, the amplification ratio of the second-stage power amplification module 133 is 17db, and the amplification ratio of the third-stage power amplification module 135 is 15db. The multiple stages of power amplification modules 13 have different amplification ratios, and the radio frequency signals are sequentially amplified by the multiple stages of power amplification modules 13 with different amplification ratios and then transmitted to the load 30 so that the load on the multiple stages of power amplification modules 13 in the process of power amplification of the radio frequency signals can be reduced, the stability of power amplification can be improved, and the accuracy of power amplification can be ensured. In another embodiment, the amplification ratios of the first-stage power amplification module 131, the second-stage power amplification module 133, and the third-stage power amplification module 135 can be the same, so that the selection is relatively simple and unified, and it is easy to replace and maintain once damaged, thus saving costs.

In some embodiments, the first-stage power amplification module 131, the second-stage power amplification module 133, and the third-stage power amplification module 135 can also be connected by coupling. For example, the coupling mode can be resistance-capacitance coupling, direct coupling, photoelectric coupling, etc., which is not limited here.

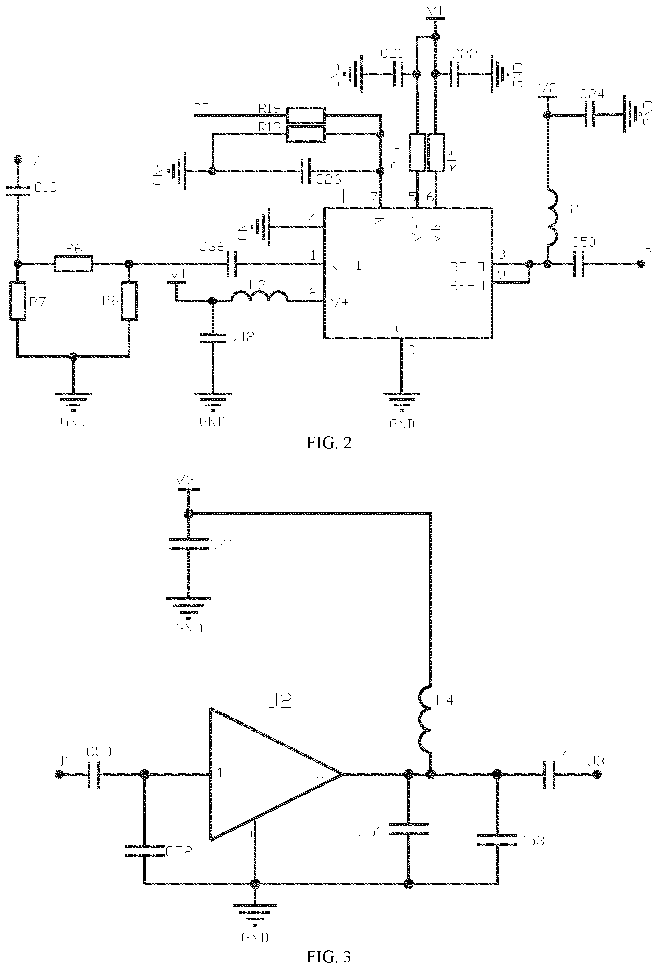

Referring to Fig. 1 and Fig. 2, in some embodiments, the first-stage power amplification module 131 includes a first chip U1, a resistor R6, a resistor R7, a resistor R8, a resistor R13, a resistor R15, a resistor R16, a resistor R19, a capacitor C21, a capacitor C22, a capacitor C24, a capacitor C26, a capacitor C36, a capacitor C42, an emitter capacitor CE, an inductor L2 and an inductor L3.

Specifically, the first pin of the first chip U1 is connected to the output pin of the voltage-controlled oscillator 11 through the capacitor C36 and the resistor R6 in series. One end of the resistor R7 is connected between the resistor R6 and the output pin of the voltage-controlled oscillator 11, and the other end of the resistor R7 is grounded to GND. One end of the resistor R8 is connected between resistor R6 and the capacitor C36, and the other end of the resistor R8 is connected with the other end of the resistor R7. The second pin of the first chip U1 is connected to one end of the inductor L3, the other end of the inductor L3 is connected to the first power supply V1, and the capacitor C42 is connected between the inductor L3 and the first power supply V1. The third pin and the fourth pin of the first chip U1 are grounded to GND. The fifth pin of the first chip U1 is connected to the first power supply V1 through the resistor R15, and one end of the capacitor C21 is connected between the first power supply V1 and the resistor R15, and the other end of the capacitor C21 is grounded to GND. The sixth pin of the first chip U1 is connected to the first power supply V1 through the resistor R16, and one end of the capacitor C22 is connected between the first power supply V1 and the R16, and the other end of the capacitor C22 is grounded to GND. The seventh pin of the first chip U1 is connected with the emitter capacitor CE through the resistor R19, one end of the capacitor C26 is connected between the resistor R19 and the seventh pin of the first chip U1, the other end of the capacitor C26 is grounded to GND; one end of the resistor R13 is connected between the resistor R19 and the seventh pin of the first chip U1, and the other end of the resistor R13 is connected with the other end of the capacitor C26. The eighth pin and the ninth pin of the first chip U1 are electrically connected and then connected with the second-stage power amplification module 133 through a DC blocking capacitor C50. One end of the inductor L2 is connected between the eighth pin of the first chip U1 and the DC blocking capacitor C50, and is connected between the ninth pin of the first chip U1 and the DC blocking capacitor C50, and the other end of the inductor L2 is connected to a second power supply V2. One end of the capacitor C24 is connected between the inductor L2 and the second power supply V2, and the other end of the capacitor C24 is grounded to GND.

The main function of the first-stage power amplification module 131 in the embodiment of the present application is to receive and amplify the high-frequency radio frequency signal generated by the voltage-controlled oscillator 11, and coupled with the second-stage power amplification module 133 through the DC blocking capacitor C50, to transmit the radio frequency signal after the first-stage amplification to the second-stage power amplification module 133.

Referring to Fig. 1 and Fig. 3, in some embodiments, the second-stage power amplification module 133 includes a second chip U2, a capacitor C41, a capacitor C51, a capacitor C52, a capacitor C53, and an inductor L4.

Specifically, the first pin of the second chip U2 is connected to the first-stage power amplification module 131 through the DC blocking capacitor C50. Specifically, please refer to Fig. 2, The first pin of the second chip U2 is connected to both the eighth pin and the ninth pin of the first chip U1 through the DC blocking capacitor C50. One end of the capacitor C52 is connected between the DC blocking capacitor C50 and the first pin of the second chip U2, and the other end of the capacitor C52 is connected with the second pin of the second chip U2. The second pin of the second chip U2 is grounded to GND. The third pin of the second chip U2 is connected to the third-stage power amplification module 135 through a DC blocking capacitor C37. One end of the inductor L4 is connected between the third pin of the second chip U2 and the DC blocking capacitor C37, and the other end of the inductor L4 is connected to a third power supply V3. One end of the capacitor C41 is connected between the inductor L4 and the third power supply V3, and the other end of the capacitor C41 is grounded to GND. One end of the capacitor C51 is connected between the third pin of the second chip U2 and the inductor L4, and the other end of the capacitor C51 is connected with the second pin of the second chip U2. One end of the capacitor C51 is connected between the inductor L4 and the DC blocking capacitor C37, and the other end of the capacitor C51 is connected with the second pin of the second chip U2.

The main function of the second-stage power amplification module 133 in the embodiment of the present application is to receive the radio frequency signal after being amplified by the first-stage power amplification module 131, perform second-stage power amplification, and then transmit the radio frequency signal after the second-stage amplification to the third-stage power amplification module 135.

Referring to Fig. 1, Fig. 4, and Fig. 5, in some embodiments, the load 30 includes a cavity 31 for storing a matrix 33 and a FMA terminal J1 disposed on the cavity 31.

Specifically, the matrix 33 is at least partially arranged in the cavity 31, and the FMA terminal J1 is connected with the third-stage power amplification module 135, so that the radio frequency signal amplified by the multiple stages of power amplification modules 13 is introduced into the cavity 31, thereby heating the matrix 33 stored in the cavity 31. It should be noted that in some embodiments, the load 31 can also introduce the radio frequency signal after power is amplified into the cavity 31 through devices such as an antenna and a probe.

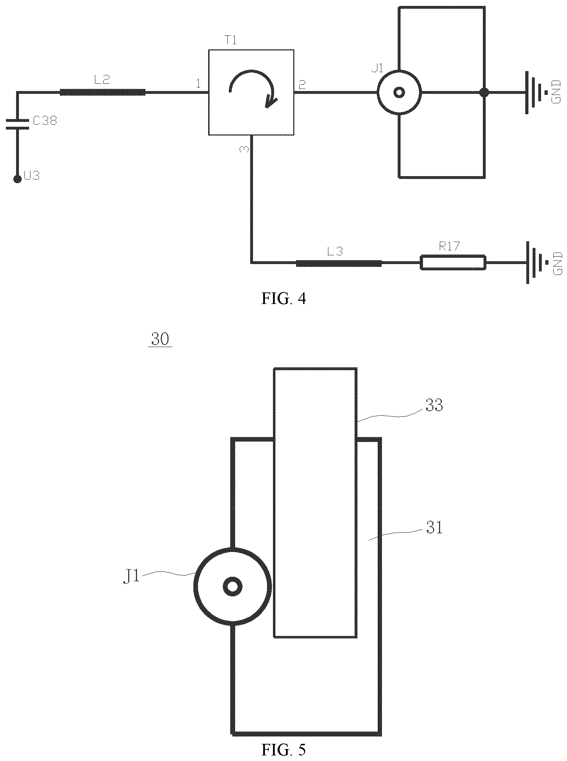

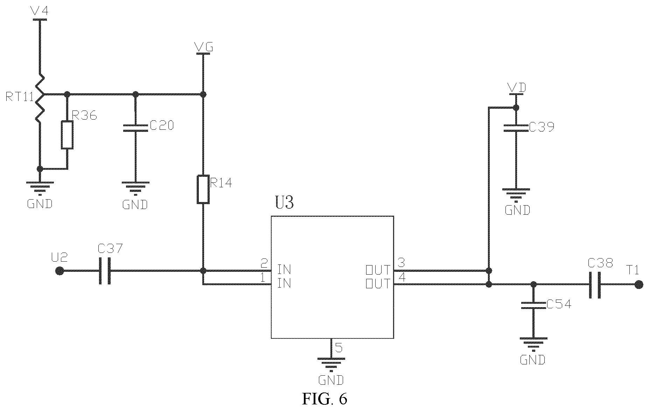

Referring to Fig. 4 to Fig. 6, in some embodiments, the third-stage power amplification module 135 includes a third chip U3, a variable resistor RT11, a resistor R14, a resistor R36, a capacitor C20, a capacitor C39, a capacitor C54, a power supply VG and a diode VD.

Specifically, the first pin and the second pin of the third chip U3 are electrically connected and then connected with the third pin of the second-stage power amplification module 133 through the DC blocking capacitor C37. One end of the resistor R14 is connected between the first pin of the third chip U3 and the DC blocking capacitor C37, and is connected between the second pin of the third chip U3 and the DC blocking capacitor C37, and the other end of the resistor R14 is connected with the power supply VG. The variable resistor RT11 is arranged between the power supply VG and the resistor R14, the first end of the variable resistor RT11 is connected to a fourth power supply V4, the second end of the variable resistor RT11 is grounded to GND, and the third end of the variable resistor RT11 is connected between the power supply VG and the resistor R14. One end of the capacitor C20 is connected between the resistor R14 and the power supply VG, and the other end of the capacitor C20 is grounded to GND. One end of the resistor R36 is connected to the third end of the variable resistor RT11, and the other end of the resistor R36 is connected to the second end of the variable resistor RT11. The third pin and the fourth pin of the third chip U3 are electrically connected and then connected with the first pin of a circulator T1 through a DC blocking capacitor C38. The second pin of the circulator T1 is connected with the FMA terminal J1; the diode VD is connected between the third pin of the third chip U3 and the DC blocking capacitor C38, and is connected between the fourth pin of the third chip U3 and the blocking capacitor C38. One end of the capacitor C39 is connected between the third pin of the third chip U3 and the diode VD, and is connected between the fourth pin of the third chip U3 and the diode VD, and the other end of the capacitor C39 is grounded to GND. One end of the capacitor C54 is connected between the DC blocking capacitor C38 and the diode VD, and the other end of the capacitor C54 is grounded to GND. The fifth pin of the third chip U3 is grounded to GND.

The circulator T1 can prevent the radio frequency signal after being amplified by the multiple stages of power amplification modules 13 from returning to the third-stage power amplification module 135 under the condition that there is no matrix 33 in the cavity 31 of the load 30 or an open circuit occurs, thereby ensuring the normal operation of the third-stage power amplification module 135 and preventing the third-stage power amplification module 135 from being damaged.

The main function of the third-stage power amplification module 135 in the embodiment of the present application is to receive the radio frequency signal amplified by the second-stage power amplification module 133, perform three-stage power amplification, and transmit the radio frequency signal after the third-stage amplification to the FMA terminal J1 on the cavity 31, thereby heating the matrix 33 stored in the cavity 31 to generate aerosol, and ensuring the suction taste of the atomization device 100.

Referring to Fig. 1, the embodiment of the present application also provides an atomization device 100. The atomization device 100 includes a microcontroller 20 and the microwave generation apparatus10 of any one of the above embodiments. The microcontroller 20 is electrically connected to the microwave generation apparatus 10.

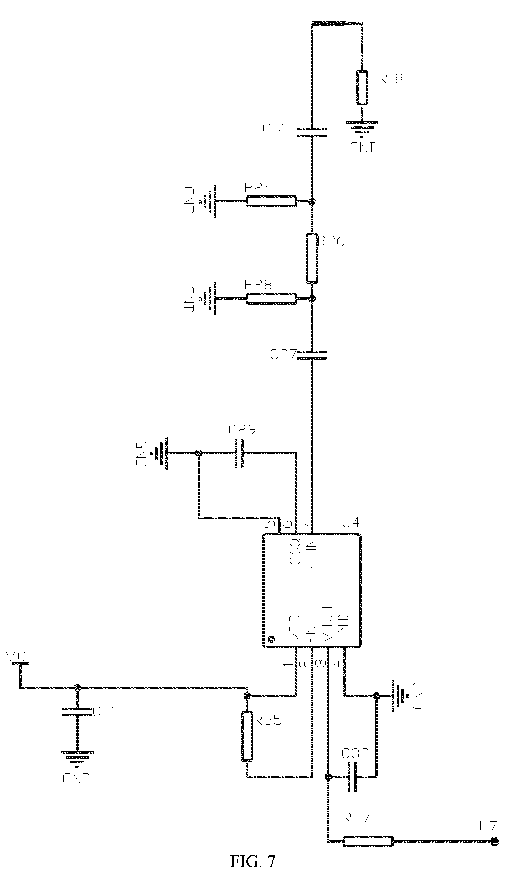

Please refer to Fig. 7. In some embodiments, the atomization device 100 may further include a forward power detection module 40. The forward power detection module 40 is used to detect the power of the radio frequency signal after being amplified by the multiple stages of power amplification modules 13 and output a first voltage to the microcontroller 20, wherein the microcontroller 20 turns off the voltage-controlled oscillator 11 when the power of the radio frequency signal is greater than or less than a preset range.

In one embodiment, the forward power detection module 40 and the multiple stages of power amplification modules 13 are arranged on the same substrate to form the integrated chip, so that the forward power detection module 40 can directly detect the radio frequency signal after being amplified by the multiple stages of power amplification modules 13, thereby improving the working efficiency of the microwave generation apparatus 10 and the atomization device 100. In addition, the forward power detection module 40 and the multiple stages of power amplification modules 13 form the integrated chip, thereby reducing the circuit area of the forward power detection module 40 and the multiple stages of power amplification modules 13 and ensuring the miniaturization of the microwave generation apparatus 10 and the atomization device 100. In another embodiment, the forward power detection module 40, the voltage-controlled oscillator 11, and the multiple stages of power amplification modules 13 are arranged on the same substrate to form the integrated chip, so that the working efficiency of the microwave generation apparatus 10 and the atomization device 100 can be further improved, and the space occupancy rate of the microwave generation apparatus 10 can be further reduced.

The forward power detection module 40 includes a fourth chip U4, a resistor R18, a resistor R24, a resistor R26, a resistor R28, a resistor R35, a resistor R37, a capacitor C27, a capacitor C29, a capacitor C31, a capacitor C33, a capacitor C61, and a power supply VCC.

Specifically, the first pin of the fourth chip U4 is connected to the power supply VCC, and one end of the capacitor C31 is connected between the first pin of the fourth chip U4 and the power supply VCC, and the other end of the capacitor C31 is grounded to GND. The second pin of the fourth chip U4 is connected to one end of the resistor R35, and the other end of the resistor R35 is connected between the first pin of the fourth chip U4 and the capacitor C31. The third pin of the fourth chip U4 is connected to the microcontroller 20 through the resistor R37. The fourth pin of the fourth chip U4 is grounded to GND; one end of the capacitor C33 is connected between the third pin of the fourth chip U4 and the resistor R37, and the other end of the capacitor C33 is connected with the fourth pin of the fourth chip U4. The fifth pin of the fourth chip U4 is grounded to GND. One end of the capacitor C29 is connected to the sixth pin of the fourth chip U4, and the other end of the capacitor C29 is connected to the fifth pin of the fourth chip U4. The seventh pin of the fourth chip U4 is grounded to GND through the capacitor C27, the resistor R26, the capacitor C61, a first coupling lines L1, and the R18 connected in series. The first coupling line L1 is coupled with a second coupling line L2 which is connected between the DC blocking capacitor C38 and the circulator T1. One end of the resistor R28 is connected between the resistor R26 and the capacitor C27, and the other end of the resistor R28 is grounded to GND. One end of the resistor R24 is connected between the resistor R26 and the capacitor C61, and the other end of the resistor R24 is grounded to GND.

In some embodiments, the forward power detection module 40 is coupled with the second coupling line L2, which is connected between the DC blocking capacitor C38 and the circulator T1, through the first coupling line L1, so that the forward power detection module 40 is arranged between the third-stage power amplification module 135 and the load 30, detects the power of the radio frequency signal after being amplified by the multiple stages of power amplification modules 13, and outputs the first voltage to the microcontroller 20. Specifically, when the first voltage output by the forward power detection module 40 to the microcontroller 20 indicates that the power of the radio frequency signal after being amplified by the multiple stages of power amplification modules 13 is greater than or less than the preset range, it indicates that the voltage-controlled oscillator 11 is damaged and/or the multiple stages of power amplification modules 13 are damaged, and the whole atomization device 100 cannot work normally. If the voltage-controlled oscillator 11 and/or the multiple stages of power amplification modules 13 are always in the working state, they are likely to be completely burned out. At this time, the microcontroller 20 can turn off the voltage-controlled oscillator 11, thereby protecting the voltage-controlled oscillator 11 and/or the multiple stages of power amplification modules 13, facilitating subsequent maintenance and avoiding damage expansion.

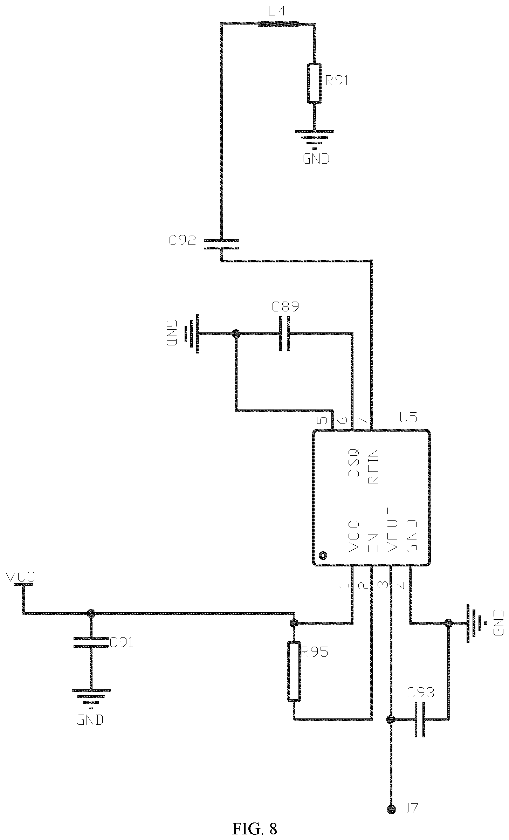

Referring to Fig. 1 and Fig. 8, in some embodiments, the atomization device 100 may further include a reverse power detection module 50. The reverse power detection module 50 is used to detect the power reflected by the microwave in the load 30 and output the second voltage to the microcontroller 20. The microcontroller 20 performs algorithmic processing on the first voltage and the second voltage to output the resonant frequency, and the microcontroller 20 controls the frequency of the radio frequency signal output by the voltage-controlled oscillator 11 according to the resonant frequency.

In one embodiment, the reverse power detection module 50 and the multiple stages of power amplification modules 13 are arranged on the same substrate to form the integrated chip, so that the circuit areas of the forward power detection module 40 and the multiple stages of power amplification modules 13 can be reduced and the miniaturization of the microwave generation apparatus 10 and the atomization device 100 can be ensured. In another embodiment, the reverse power detection module 50, the voltage-controlled oscillator 11, and the multiple stages of power amplification modules 13 are arranged on the same substrate to form the integrated chip, thereby further reducing the space occupancy rate of the microwave generation apparatus 10.

The reverse power detection module 50 includes a fifth chip U5, a resistor R91, a resistor R95, a capacitor C89, a capacitor C91, a capacitor C92, a capacitor C93, and a power supply VCC.

Specifically, the first pin of the fifth chip U5 is connected to the power supply VCC. One end of the capacitor C91 is connected between the first pin of the fifth chip U5 and the power supply VCC, and the other end of the capacitor C91 is grounded to GND. The second pin of the fifth chip U5 is connected to one end of the resistor R95, and the other end of the resistor R95 is connected between the first pin of the fifth chip U5 and the capacitor C91. The third pin of the fifth chip U5 is connected to the microcontroller 20. One end of the capacitor C93 is connected between the third pin of the fifth chip U5 and the microcontroller 20, the other end of the capacitor C93 is connected with the fourth pin of the fifth chip U5, and the fourth pin of the fifth chip U5 is grounded to GND. The fifth pin of the fifth chip U5 is grounded to GND. The sixth pin of the fifth chip U5 is connected to one end of the capacitor C89, and the other end of the capacitor C89 is connected to the fifth pin of the fifth chip U5. Please refer to Fig. 4, one end of resistor R17 is connected to the third end of the circulator T1 through a third coupling line L3, and the other end of the resistor R17 is grounded to GND. The seventh pin of the fifth chip U5 is grounded to GND through the capacitor C92, a fourth coupling line L4, and the resistor R91 connected in series, and the fourth coupling line L4 is coupled to the first coupling line L1.

In some embodiments, the reverse power detection module 50 is coupled with the third coupling line L3 connected between the resistor R17 and the circulator T1 through the fourth coupling line L4, to detect the power reflected by the microwave in the load 30 and output the second voltage to the microcontroller 20. The microcontroller 20 performs algorithmic processing on the first voltage and the second voltage to output a resonant frequency, and adjusts the frequency of the radio frequency signal output by the voltage-controlled oscillator 11 according to the resonant frequency, so that the frequency of the radio frequency signal changes within a certain frequency range, to effectively control the power of the microwave in the cavity 31, ensure the stability of the taste of the atomization device 100, and improve the user experience.

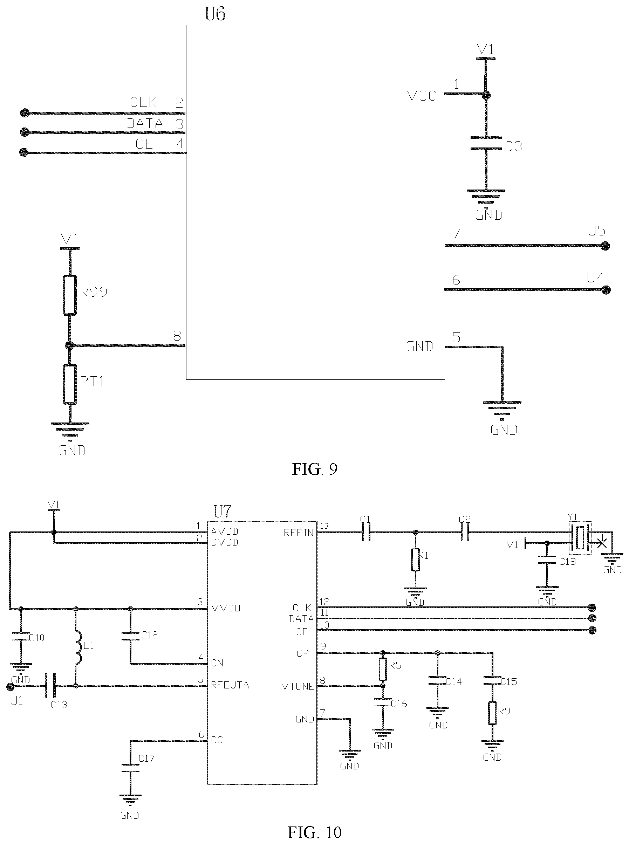

Referring to Fig. 1 and Fig. 9, in some embodiments, the atomization device 100 may further include a temperature detection module 60. Wherein the temperature detection module 60 includes a thermistor RT1 and a resistor R99. One end of the resistor R99 is electrically connected to the microcontroller 20, and the other end of the resistor R99 is connected to the first power supply V1. One end of thermistor RT1 is connected between the microcontroller 20 and the resistor R99, and the other end of the thermistor RT1 is grounded to GND.

In some embodiments, the value of the thermistor RT1 in the temperature detection module 60 can change with the change of the temperature in the load 30, thereby outputting a third voltage to the microcontroller 20. When the temperature in the load 30 is greater than the preset temperature range, the microcontroller 20 turns off the voltage-controlled oscillator 11. Specifically, when the temperature in the load 30 is greater than the preset temperature range, the matrix 33 in the cavity 31 of the load 30 will generate a certain amount of harmful substances due to the high temperature, such as formaldehyde, nicotine, etc., which is harmful to the health of users. Therefore, when the temperature in the load 30 is greater than the preset temperature range, the third voltage output by the temperature detection module 60 to the microcontroller 20 can indicate the temperature abnormality in the load 30, and the microcontroller 20 will turn off the voltage-controlled oscillator 11, and then turn off the atomization device 100, to prevent the excessive temperature from generating harmful substances and endangering the health of smokers. It should be noted that in some embodiments, the preset temperature range can be adjusted according to the type of the matrix 33, the use environment, and other specific conditions.

Referring to Fig. 1 and Fig. 9, in some embodiments, the microcontroller 20 may include a sixth chip U6 and a capacitor C3.

Specifically, the first pin of the sixth chip U6 is connected to the first power supply V1, and one end of the capacitor C3 is connected between the first pin of the sixth chip U6 and the first power supply V1, and the other end of the capacitor C3 is grounded to GND. The second pin, the third pin, and the fourth pin of the sixth chip U6 are all electrically connected with the voltage-controlled oscillator 11. The fifth pin of the sixth chip U6 is grounded to GND. The sixth pin of the sixth chip U6 is electrically connected with the third pin of the reverse power detection module 50. The seventh pin of the sixth chip U6 is electrically connected with the third pin of the forward power detection module 40. The eighth pin of the sixth chip U6 is electrically connected with the temperature detection module 60.

Referring to Fig. 1 and Fig. 10, in some embodiments, the voltage-controlled oscillator 11 may include a seventh chip U7, a resistor R1, a resistor R5, a resistor R9, a capacitor C1, a capacitor C2, a capacitor C10, a capacitor C12, a capacitor C14, a capacitor C15, a capacitor C16, a capacitor C17, a capacitor C18, an inductor L1, and a crystal oscillator Y1.

Specifically, the first pin, the second pin, and the third pin of the seventh chip U7 are electrically connected and then connected to the first power supply V1. One end of the capacitor C10 is connected between the first power supply V1 and the third pin of the seventh chip U7, and the other end of the capacitor C10 is grounded to GND. The fourth pin of the seventh chip U7 is connected to one end of the capacitor C12, and the other end of the capacitor C12 is connected between the capacitor C10 and the third pin of the seventh chip U7. The fifth pin of the seventh chip U7 is connected with the resistor R6 of the first-stage power amplification module 131 through a DC blocking capacitor C13. One end of the inductor L1 is connected between the capacitor C10 and the capacitor C12, and the other end of the inductor L1 is connected between the DC blocking capacitor C13 and the fifth pin of the seventh chip U7. The sixth pin of the seventh chip U7 is connected to one end of the capacitor C17, and the other end of the capacitor C17 is grounded to GND. The seventh pin of the seventh chip U7 is grounded to GND. The eighth pin of the seventh chip U7 is connected to one end of the capacitor C16, and the other end of the capacitor C16 is grounded to GND. The ninth pin of the seventh chip U7 is connected with one end of the resistor R9 through the capacitor C15, the other end of the resistor R9 is grounded to GND; one end of the resistor R5 is connected between the ninth pin of the seventh chip U7 and the capacitor C15, and the other end of the resistor R5 is connected between the eighth pin of the seventh chip U7 and the capacitor C16; and one end of the capacitor C14 is connected between the resistor R5 and the capacitor C15, and the other end of the capacitor C14 is grounded to GND. The tenth pin, eleventh pin, and twelfth pin of the seventh chip U7 are respectively electrically connected with the fourth pin, third pin, and second pin of the microcontroller 20. The thirteenth pin of the seventh chip U7 is connected with the third pin of the crystal oscillator Y1 through the capacitors C1 and the capacitor C2 connected in series, the fourth pin of the crystal oscillator Y1 is connected with the first power supply V1, the first pin of the crystal oscillator Y1 is floating, the second pin of the crystal oscillator Y1 is grounded to GND; one end of the resistor R1 is connected between the capacitors C1 and C2, the other end of the resistor R1 is grounded to GND; and one end of the capacitor C18 is connected between the fourth pin of the crystal oscillator Y1 and the first power supply V1, and the other end of the capacitor C18 is grounded to GND.

In some embodiments, the crystal oscillator Y1 can be an active crystal oscillator or a passive crystal oscillator, which is not limited here. The crystal oscillator Y1 can cooperate with the voltage-controlled oscillator 11 to output a more stable high-frequency radio frequency signal.

Among them, the DC blocking capacitor C13, the DC blocking capacitor C37, the DC blocking capacitor C38, and the DC blocking capacitor C50 primarily utilize their DC blocking and AC impeding characteristics, so that high-frequency radio frequency signals can pass through the circuit smoothly, and the power is amplified by the multiple stages of power amplification modules 13, to prevent the phenomenon that the previous stage power amplification module and the latter stage power amplification module are connected in series or affect each other, which will affect the normal operation of the multiple stages of power amplification modules 13.

When the atomization device 100 is in operation, firstly, the microcontroller 20 is electrically connected with the tenth pin, the eleventh pin, and the twelfth pin of the voltage-controlled oscillator 11 through its second pin, the third pin, and the fourth pin, respectively, and turns on the voltage-controlled oscillator 11 via I2C communication. Then, the voltage-controlled oscillator 11 outputs a radio frequency signal corresponding to the operating frequency (for example, 2.45GHz). After that, the radio frequency signal is power amplified by the multiple stages of power amplification modules 13. Subsequently, the power-amplified radio frequency signal passes through the circulator T1 and is input into the cavity 31 of the load 30 through the FMA terminal J1 to heat the matrix 33 in the cavity 31. In the heating process, the atomization device 100 can detect the power of the radio frequency signal amplified by the multiple stages of power amplification modules 13 through the forward power detection module 40, and output the first voltage to the microcontroller 20. The reverse power detection module 50 detects the power reflected by the microwave in the load 30 and outputs a second voltage to the microcontroller 20. The microcontroller 20 performs algorithmic processing on the first voltage and the second voltage to output the resonant frequency, so that the microcontroller 20 controls the frequency of the radio frequency signal output by the voltage-controlled oscillator 11 according to the resonant frequency. At the same time, the atomization device 100 also detects the temperature in the load 30 through the temperature detection module 60. When the temperature in the load 30 is greater than the preset temperature range, the microcontroller 20 turns off the voltage-controlled oscillator 11.

The atomization device 100 of the present application is provided with the multiple stages of power amplification modules 13 connected in series, to increase the power of the radio frequency signal sent by the voltage-controlled oscillator 11, fully meet the power demand of the atomization device 100, ensure the improvement of the atomization taste and aerosol quantity, and avoid the mismatch of power failing to produce atomization or insufficient atomization that affects the taste. At the same time, the multiple stages of power amplification modules 13 are arranged on the same substrate to form an integrated chip, which reduces the space occupied by the multiple stages of power amplification modules 13, improves the efficiency of the overall amplification link and ensures the miniaturization of the microwave generation apparatus 10 and the atomization device 100.

In addition, the atomization device 100 is provided with a forward power detection module 40 to detect the power after being amplified by the multiple stages of power amplification modules 13 and output the first voltage to the microcontroller 20. When the power is greater than or less than the preset range, the microcontroller 10 turns off the voltage-controlled oscillator 11, thus protecting the circuit. The atomization device 100 is also provided with a reverse power detection module 50 to detect the power reflected by the microwave in the load 30, and output a second voltage. Together with the first voltage, the second voltage is processed by the algorithm of the microcontroller 20 to obtain the resonant frequency, thereby controlling the frequency generated by the voltage-controlled oscillator 11, ensuring the consistency of aerosol quantity generated by the atomization device 100 and maintaining the consistency of taste. In addition, the atomization device 100 is provided with a temperature detection module 60 to detect the temperature of the load 30, so that on the one hand, the problem that harmful substances are generated in the matrix 33 in the cavity 31 due to excessive temperature can be avoided, and on the other hand, other components in the circuit can be protected from being damaged due to high temperature.

In the description of this specification, descriptions referring to the terms "one embodiment", "some embodiments", "examples", "specific examples" or "some examples" mean that specific features, structures, materials, or characteristics described in connection with this embodiment or example are included in at least one embodiment or example of this application. In this specification, the schematic descriptions of the above terms are not necessarily aimed at the same embodiment or example. Moreover, the specific features, structures, materials, or characteristics described may be combined in any one or more embodiments or examples in a suitable manner. In addition, those skilled in the art can combine different embodiments or examples and features of different embodiments or examples described in this specification without contradicting each other.

Any process or method description in the flowchart or otherwise described herein can be understood as representing a module, segment, or part of code that includes one or more executable instructions for implementing specific logical functions or steps of the process, and the scope of preferred embodiments of the present application includes other implementations, in which functions can be performed out of the order shown or discussed, including in a substantially simultaneous manner or the reverse order according to the functions involved, which should be understood by those skilled in the technical field to which embodiments of the present application belong.

Although the embodiments of the present application have been shown and described above, it can be understood that the above embodiments are exemplary and cannot be understood as limitations of the present application, and those skilled in the art can make changes, modifications, substitutions and variations to the above embodiments within the scope of the present application.

## Claims

1. A microwave generation apparatus, comprising:
a voltage-controlled oscillator for generating a high-frequency radio frequency signal; and
series-connected multiple stages of power amplification modules are connected with the voltage-controlled oscillator and used for receiving the radio frequency signal and performing power amplification on the radio frequency signal to output the amplified radio frequency signal to a load, and the multiple stages of power amplification modules are arranged on the same substrate to form an integrated chip.

2. The microwave generation apparatus according to claim 1, wherein the multiple stages of power amplification modules and the voltage-controlled oscillator are arranged on the same substrate to form the integrated chip.

3. The microwave generation apparatus according to claim 1, wherein the multiple stages of power amplification modules comprise a first-stage power amplification module, a second-stage power amplification module, and a third-stage power amplification module; the first-stage power amplification module, the second-stage power amplification module, and the third-stage power amplification module are sequentially connected in series between the voltage-controlled oscillator and the load, and amplify the radio frequency signal output by the voltage-controlled oscillator stage by stage.

4. The microwave generation apparatus according to claim 3, wherein the first-stage power amplification module comprises a first chip, a resistor R6, a resistor R7, a resistor R8, a resistor R13, a resistor R15, a resistor R16, a resistor R19, a capacitor C21, a capacitor C22, a capacitor C24, a capacitor C26, a capacitor C36, a capacitor C42, an emitter capacitor CE, an inductor L2, and an inductor L3, the first pin of the first chip is connected to the output pin of the voltage-controlled oscillator through the capacitor C36 and the resistor R6 in series; one end of the resistor R7 is connected between the resistor R6 and the output pin of the voltage-controlled oscillator, and the other end of the resistor R7 is grounded; one end of the resistor R8 is connected between the resistor R6 and the capacitor C36, and the other end of the resistor R8 is connected with the other end of the resistor R7; the second pin of the first chip is connected with one end of the inductor L3, the other end of the inductor L3 is connected with a first power supply, and the capacitor C42 is connected between the inductor L3 and the first power supply; the third pin and the fourth pin of the first chip are grounded; the fifth pin of the first chip is connected with the first power supply through the resistor R15, one end of the capacitor C21 is connected between the first power supply and the resistor R15, and the other end of the capacitor C21 is grounded; the sixth pin of the first chip is connected with the first power supply through the resistor R16, and one end of the capacitor C22 is connected between the first power supply and the R16, and the other end of the capacitor C22 is grounded; the seventh pin of the first chip is connected with the emitter capacitor CE through the resistor R19, one end of the capacitor C26 is connected between the resistor R19 and the seventh pin of the first chip, the other end of the capacitor C26 is grounded; one end of the resistor R13 is connected between the resistor R19 and the seventh pin of the first chip, and the other end of the resistor R13 is connected with the other end of the capacitor C26; the eighth pin and the ninth pin of the first chip are electrically connected and then connected with the second-stage power amplification module through a DC blocking capacitor C50; one end of the inductor L2 is connected between the eighth pin of the first chip and the DC blocking capacitor C50, and is connected between the ninth pin of the first chip and the DC blocking capacitor C50, and the other end of the inductor L2 is connected with a second power supply; one end of the capacitor C24 is connected between the inductor L2 and the second power supply, and the other end of the capacitor C24 is grounded.

5. The microwave generation apparatus according to claim 3, wherein the second-stage power amplification module comprises a second chip, a capacitor C41, a capacitor C51, a capacitor C52, a capacitor C53, and an inductor L4, the first pin of the second chip is connected with the first-stage power amplification module through a DC blocking capacitor C50, and one end of the capacitor C52 is connected between the DC blocking capacitor C50 and the first pin of the second chip, and the other end of the capacitor C52 is connected with the second pin of the second chip; the second pin of the second chip is grounded; the third pin of the second chip is connected with the third-stage power amplification module through a DC blocking capacitor C37, one end of the inductor L4 is connected between the third pin of the second chip and the DC blocking capacitor C37, and the other end of the inductor L4 is connected with a third power supply; one end of the capacitor C41 is connected between the inductor L4 and the third power supply, and the other end of the capacitor C41 is grounded; one end of the capacitor C51 is connected between the third pin of the second chip and the inductor L4, and the other end of the capacitor C51 is connected with the second pin of the second chip; one end of the capacitor C51 is connected between the inductor L4 and the DC blocking capacitor C37, and the other end of the capacitor C51 is connected with the second pin of the second chip.

6. The microwave generation apparatus according to claim 3, wherein the load comprises a cavity for storing a matrix and a FMA terminal arranged on the cavity; the third-stage power amplification module comprises a third chip, a variable resistor RT11, a resistor R14, a resistor R36, a capacitor C20, a capacitor C39, a capacitor C54, a power supply VG, and a diode VD; the first pin and the second pin of the third chip are electrically connected and then connected with the second-stage power amplification module through a DC blocking capacitor C37; one end of the resistor R14 is connected between the first pin of the third chip and the DC blocking capacitor C37, and is connected between the second pin of the third chip and the DC blocking capacitor C37, the other end of the resistor R14 is connected with the power supply VG; the variable resistor RT11 is arranged between the power supply VG and the resistor R14, the first end of the variable resistor RT11 is connected with a fourth power supply, the second end of the variable resistor RT11 is grounded, and the third end of the variable resistor RT11 is connected between the power supply VG and the resistor R14; one end of the capacitor C20 is connected between the resistor R14 and the power supply VG, and the other end of the capacitor C20 is grounded; one end of the resistor R36 is connected to the third end of the variable resistor RT11, and the other end of the resistor R36 is connected to the second end of the variable resistor RT11; the third pin and the fourth pin of the third chip are electrically connected and then connected with the first pin of a circulator T1 through a DC blocking capacitor C38; the second pin of the circulator T1 is connected with the FMA terminal; the diode VD is connected between the third pin of the third chip and the DC blocking capacitor C38, and is connected between the fourth pin of the third chip and the DC blocking capacitor C38; one end of the capacitor C39 is connected between the third pin of the third chip and the diode VD, and is connected between the fourth pin of the third chip and the diode VD, and the other end of the capacitor C39 is grounded; one end of the capacitor C54 is connected between the DC blocking capacitor C38 and the diode VD, and the other end of the capacitor C54 is grounded; the fifth pin of the third chip is grounded.

7. The microwave generation apparatus according to claim 1, wherein the material of the substrate is at least one of ceramic or metal.

8. An atomization device, comprising:
the microwave generation apparatus according to any one of claims 1 to 7; and
a microcontroller, which is electrically connected with the microwave generation apparatus.

9. The atomization device according to claim 8, wherein the atomization device further comprises:
a forward power detection module, which is used for detecting the power of the radio frequency signal after being amplified by the multiple stages of power amplification modules and outputting a first voltage to the microcontroller, wherein the microcontroller turns off the voltage-controlled oscillator when the power of the radio frequency signal is greater than or less than a preset range.

10. The atomization device according to claim 9, wherein the forward power detection module and the multiple stages of power amplification modules are arranged on the same substrate to form the integrated chip; or
the forward power detection module, the voltage-controlled oscillator, and the multiple stages of power amplification modules are arranged on the same substrate to form the integrated chip.

11. The atomization device according to claim 9, wherein the forward power detection module comprises a fourth chip, a resistor R18, a resistor R24, a resistor R26, a resistor R28, a resistor R35, a resistor R37, a capacitor C27, a capacitor C29, a capacitor C31, a capacitor C33, a capacitor C61, and a power supply VCC, wherein the first pin of the fourth chip is connected with the power supply VCC, and one end of the capacitor C31 is connected between the first pin of the fourth chip and the power supply VCC, and the other end of the capacitor C31 is grounded; the second pin of the fourth chip is connected with one end of the resistor R35, and the other end of the resistor R35 is connected between the first pin of the fourth chip and the capacitor C31; the third pin of the fourth chip is connected with the microcontroller through the resistor R37; the fourth pin of the fourth chip is grounded; one end of the capacitor C33 is connected between the third pin of the fourth chip and the resistor R37, and the other end of the capacitor C33 is connected with the fourth pin of the fourth chip; the fifth pin of the fourth chip is grounded; one end of the capacitor C29 is connected with the sixth pin of the fourth chip, and the other end of the capacitor C29 is connected with the fifth pin of the fourth chip; the seventh pin of the fourth chip is grounded through the capacitor C27, the resistor R26, the capacitor C61, a first coupling line, and the R18 connected in series, the first coupling line is coupled with a second coupling line which is connected between the DC blocking capacitor C38 and the circulator T1; one end of the resistor R28 is connected between the resistor R26 and the capacitor C27, and the other end of the resistor R28 is grounded; one end of the resistor R24 is connected between the resistor R26 and the capacitor C61, and the other end of the resistor R24 is grounded.

12. The atomization device according to claim 9, wherein the atomization device further comprises:
a reverse power detection module, which is used for detecting the power reflected by the microwave in the load and outputting a second voltage to the microcontroller, and the microcontroller performs algorithmic processing on the first voltage and the second voltage to output a resonant frequency, and the microcontroller controls the frequency of the radio frequency signal output by the voltage-controlled oscillator according to the resonant frequency.

13. The atomization device according to claim 12, wherein the reverse power detection module and the multiple stages of power amplification modules are arranged on the same substrate to form the integrated chip; or
the reverse power detection module, the voltage-controlled oscillator, and the multiple stages of power amplification modules are arranged on the same substrate to form the integrated chip.

14. The atomization device according to claim 12, wherein the reverse power detection module comprises a fifth chip, a resistor R91, a resistor R95, a capacitor C89, a capacitor C91, a capacitor C92, a capacitor C93, and a power supply VCC, the first pin of the fifth chip is connected with the power supply VCC; one end of the capacitor C91 is connected between the first pin of the fifth chip and the power supply VCC, and the other end of the capacitor C91 is grounded; the second pin of the fifth chip is connected with one end of the resistor R95, and the other end of the resistor R95 is connected between the first pin of the fifth chip and the capacitor C91; the third pin of the fifth chip is connected with the microcontroller; one end of the capacitor C93 is connected between the third pin of the fifth chip and the microcontroller, and the other end of the capacitor C93 is connected with the fourth pin of the fifth chip, and the fourth pin of the fifth chip is grounded; the fifth pin of the fifth chip is grounded; the sixth pin of the fifth chip is connected with one end of the capacitor C89, and the other end of the capacitor C89 is connected with the fifth pin of the fifth chip; one end of resistor R17 is connected with circulator T1 through a third coupling line, and the other end of the resistor R17 is grounded; the seventh pin of the fifth chip is grounded through the capacitor C92, a fourth coupling line, and the resistor R91 connected in series, and the fourth coupling line is coupled with the first coupling line.

15. The atomization device according to claim 8, wherein the atomization device further comprises:
a temperature detection module, which detects the temperature in the load and outputs a third voltage; wherein the microcontroller turns off the voltage-controlled oscillator when the temperature in the load is greater than a preset temperature range.

16. The atomization device according to claim 15, wherein the temperature detection module comprises a thermistor RT1 and a resistor R99, one end of the resistor R99 is electrically connected with the microcontroller, and the other end of the resistor R99 is connected with a first power supply; one end of the thermistor RT1 is connected between the microcontroller and the resistor R99, and the other end of the thermistor RT1 is grounded.

17. The atomization device according to claim 8, wherein the microcontroller comprises a sixth chip and a capacitor C3, the first pin of the sixth chip is connected with a first power supply, one end of the capacitor C3 is connected between the first pin of the sixth chip and the first power supply, and the other end of the capacitor C3 is grounded; the second pin, the third pin, and the fourth pin of the sixth chip are all electrically connected with the voltage-controlled oscillator; the fifth pin of the sixth chip is grounded; the sixth pin of the sixth chip is electrically connected with the reverse power detection module; the seventh pin of the sixth chip is electrically connected with the forward power detection module; the eighth pin of the sixth chip is electrically connected with the temperature detection module.

18. The atomization device according to claim 8, wherein the voltage-controlled oscillator comprises a seventh chip, a resistor R1, a resistor R5, a resistor R9, a capacitor C1, a capacitor C2, a capacitor C10, a capacitor C12, a capacitor C14, a capacitor C15, a capacitor C16, a capacitor C17, a capacitor C18, an inductor L1, and a crystal oscillator Y1, the first pin, the second pin, and the third pin of the seventh chip are electrically connected and then connected with a first power supply; one end of the capacitor C10 is connected between the first power supply and the third pin of the seventh chip, and the other end of the capacitor C10 is grounded; the fourth pin of the seventh chip is connected with one end of the capacitor C12, and the other end of the capacitor C12 is connected between the capacitor C10 and the third pin of the seventh chip; the fifth pin of the seventh chip is connected with the first-stage power amplification module through a DC blocking capacitor C13, and one end of the inductor L1 is connected between the capacitor C10 and the capacitor C12, and the other end of the inductor L1 is connected between the DC blocking capacitor C13 and the fifth pin of the seventh chip; the sixth pin of the seventh chip is connected with one end of the capacitor C17, and the other end of the capacitor C17 is grounded; the seventh pin of the seventh chip is grounded;
the eighth pin of the seventh chip is connected with one end of the capacitor C16, and the other end of the capacitor C16 is grounded; the ninth pin of the seventh chip is connected with one end of the resistor R9 through the capacitor C15, the other end of the resistor R9 is grounded; one end of the resistor R5 is connected between the ninth pin of the seventh chip and the capacitor C15, the other end of the resistor R5 is connected between the eighth pin of the seventh chip and the capacitor C16; one end of the capacitor C14 is connected between the resistor R5 and the capacitor C15, and the other end of the capacitor C14 is grounded; the tenth pin, the eleventh pin, and the twelfth pin of the seventh chip are all electrically connected with the microcontroller; the thirteenth pin of the seventh chip is connected with the third pin of the crystal oscillator Y1 through the capacitor C1 and the capacitor C2 connected in series, the fourth pin of the crystal oscillator Y1 is connected with the first power supply, the first pin of the crystal oscillator Y1 is floating, the second pin of the crystal oscillator Y1 is grounded; one end of the resistor R1 is connected between the capacitor C1 and the capacitor C2, and the other end of the resistor R1 is grounded; one end of the capacitor C18 is connected between the fourth pin of the crystal oscillator Y1 and the first power supply, and the other end of the capacitor C18 is grounded.
